# EUROPEAN PATENT SPECIFICATION

(11) **EP 0 471 619 B1**
(45) Date of publication and mention of the grant of the patent: **02.07.1997**
(21) Application number: 91402234.8
(22) Date of filing: 12.08.1991
(51) Int. Cl.: H05K 13/04, H05K 3/34, B23K 3/04, B23K 1/008, H05K 3/04

(54) **Solder reflow furnace**
Ofen für Rückflusslöten
Fourneau pour le soudage à reflux

(30) Priority: 13.08.1990 JP 85593/90; 08.01.1991 JP 17855/91
(43) Date of publication of application: 19.02.1992
(73) Proprietor: SENJU METAL INDUSTRY CO., LTD., Tokyo (JP)
(72) Inventor: Okuno, Tetsuya, c/o Sohka Factory, Senju Metal Ind, Sohka-shi, Saitama-ken (JP); Nauchi, Takashi, c/o Sohka Factory, Senju Metal, Adachi-ku, Tokyo (JP)
(74) Representative: Martin, Jean-Jacques

(56) References cited:
- EP-A- 0 109 892
- GB-A- 2 027 062
- US-A- 4 538 757
- DATABASE WPIL Week 8636, Derwent Publications Ltd., London, GB; AN 86-236483;& JP-A-61167051

## Description

The present invention relates to a reflow furnace for use in soldering of electronic components to a printed-circuit board using solder paste, and particularly to a reflow furnace in which soldering is carried out in an inert atmosphere.

Generally, soldering with solder paste has been carried out in a reflow furnace in the presence of air, i. e., oxygen. However, soldering in air results in a lot of soldering defects, e. g., formation of unsoldered portions and minute solder balls, which are caused by the presence of oxygen in the air. This is because the oxygen contained in the air easily oxidizes the soldering surface being heated in the furnace, and the oxidized surface adversely affects the spreading of molten solder. Furthermore, if solder alloy particles having a large surface area and contained in a solder paste are oxidized, they will loose their properties as metals, resulting in formation of minute solder balls from the oxidized solder alloy particles.

It is known that if heating is carried out in the absence of oxygen, i.e., in an inert gas atmosphere such as one containing nitrogen gas, carbon dioxide gas, or argon gas, soldering can be carried out successfully without occurrence of any soldering defects. See Japanese Patent Application Laid-Open Specifications No. 64-83395/1989, No. 1-118369/1989, and No. 2-44185/1990.

In a solder reflow furnace containing an inert gas atmosphere (hereunder referred to merely as "reflow furnace"), the oxygen content is restricted to 3% by volume or less in order to diminish soldering defects when the soldering is carried out using solder paste, which is generally accepted as being superior with respect to solderbility. However, in the case of a solder paste employing an RMA flux (Mildly-Activated Rosin flux), it is desirable to restrict the oxygen content to 1000 ppm (volume) or less, i.e., 0.1% by volume or less. An RMA flux is a flux in which the content of an activating agent is reduced to as low a level as possible, so that washing of the flux after soldering can be eliminated.

In the case of conventional furnaces, when a large amount of nitrogen gas is introduced into the furnace, excess nitrogen gas flows out of the furnace through the inlet and outlet ports. It has been thought, therefore, that no air comes into the furnace. However, according to the experiences of the present inventors, it is inevitable that air comes into the furnace to increase the oxygen content to higher than 1000 ppm (volume) even if a large amount of nitrogen gas is supplied into the furnace. This tendency is marked for a reflow furnace of the gas circulating type.

Publication EP-A-0 109 892 teaches to provide gaseous barriers at the inlet and the outlet of the furnace to insulate the furnace from outside, such barriers consisting in a inert gas distributor combined with flaps for canalizing the gas flow while permitting the passing of articles.

Japanese Patent Application Laid-Open Specification No. 62-183960/1987 proposes the provision of a shutter at the outlet and inlet ports of a reflow furnace so as to decrease the oxygen content in the atmosphere within the furnace. However, a reflow furnace with shutters installed at its entrances has many disadvantages. For example, it is impossible to use a conveyer so as to carry printed circuit boards into and out of the furnace, and instead a pusher must be used to transport printed circuit boards through the furnace. A continuous carrying system cannot be achieved using a pusher and this markedly decreases productivity. Furthermore, the provision of shutters and pushers makes the structure of the reflow furnace complicated, and it is rather difficult to synchronize the pusher with the shutter when printed circuit boards are taken into or taken out of the furnace.

The object of the present invention is to provide a solder reflow furnace in which the inflow of air can be suppressed drastically even when the furnace employs a conveyer.

The inventors of the present invention discovered that when a gaseous medium within a furnace exits the furnace in a turbulent flow, air from the outside gets into the furnace through this turbulent flow area. It occurred to the present inventors that when a large number of concrete blocks, i.e., "Tetrapod (trademark)" are placed on the seashore, the blocks resist incoming waves, and the waves loose their energy after they pass through many rows of concrete blocks so that the turbulence disappears.

The solder reflow furnace of the present invention has an inlet port and an outlet port, a conveyer for carrying printed circuit boards through said inlet port, said furnace and said outlet port, piping to supply an inert gas into the furnace to maintain an inert gas atmosphere within the furnace, gas flow resistant members allowing the passage of said boards and is characterized in that said inlet and said outlet ports are such that said inert gas may flow out the furnace through said inlet and said outlet ports and in that said gas flow resistant members are provided in air prevention zones upstream said inlet port and downstream said outlet port to decrease the turbulence of the inert gas flowing out of the furnace, whereby preventing outsideair from flowing into the furnace.

According to the present invention, the gas-flow-resistant member may be of any shape which can act as an obstruction to the passage of gas, but not obstructing a continuous running of a conveyer.

In a preferred embodiment, the member may be a flexible piece of a heat-resistant resin film or plate. A gas-flow-resistant member of this type is easily available on the market and is effective for preventing air from getting into the furnace.

The flexible pieces of a heat-resistant resin may be arranged at random. However, it is preferable that they are arranged such that many rows of the flexible pieces are arranged like a plurality of panels or curtains disposed at intervals transversely with respect to the direction of travel of the printed circuit boards.

According to such a preferred embodiment, a turbulent flow of gas is changed to a steady flow while it passes through the air preventing zone so that air is successfully prevented from getting into the furnace. Since the pieces of heat-resistant resin are flexible, they do not move the electronic components installed on the printed circuit boards even if the pieces contact the components while they are travelling along the conveying line of the furnace. When it is advisable for the flexible pieces not to contact the printed circuit boards, they may be separated from the boards. Even in this arrangement, air can be substantially prevented from getting into the furnace.

The flexible pieces may be provided in the top portion of the air-preventing zone in a manner such that they hang down over the printed circuit boards.

A heat-resistant resin piece which can be used in the present invention includes a polyimide film having a thickness of 0.025 - 2 mm, available under the trademark "Kapton" from Toray-DuPont.

The flow-resistant members may also comprise a plurality of metal plates disposed at intervals transversely with respect to the direction of travel of the printed circuit boards. An example of the metal plate is a stainless steel or aluminum plate. With this arrangement, too, air can be prevented successfully from getting into the furnace.

The flow-resistant members may be provided in the top and/or bottom portions of the air prevention zone. Preferably, the flow-resistant members are provided on both of the top and bottom of the air prevention zone.

In still another embodiment, the flow-resistant member may be an irregularly-shaped plate or block, like a washboard placed parallel with the printed circuit board.
Figure 1 is a longitudinal, schematic sectional view of a solder reflow furnace of the present invention;
Figure 2 is a perspective view of an air prevention zone in which flow-resistant members are provided on both of the top and bottom portions; and
Figure 3 is a perspective view of an air prevention zone in which flow-resistant members are provided only on the top portion thereof.

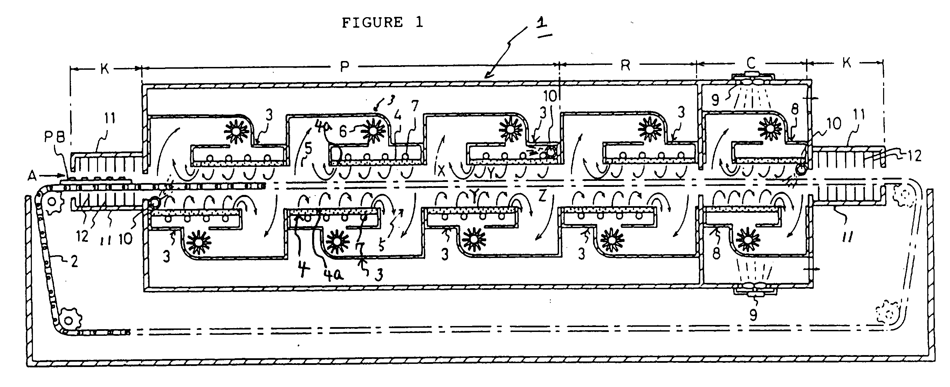

As shown in Figures 1 - 3, a solder reflow furnace 1 of the present invention comprises a preheating zone P, a main heating zone R, a cooling zone C, and air prevention zones K, K. A conveyer 2 comprising a pair of support guides 2a travels through the reflow furnace 1 to convey a printed circuit board PB in the direction A.

The solder reflow furnace illustrated in Figure 1 is of the gas-circulating type, and a series of pairs of heaters 3, 3 of the surface-blowing type are provided on the top and bottom portions of the main heating zone R and the preheating zone P. The surface-blowing heater 3 is that in which a hot blowing port 4 and a gas-drawing port 5 are provided in the same plane, a fan 6 provided within the furnace draws in gas through the gas-drawing port 5, and this gas is heated by a series of electric heaters 7 so that the heated hot gas is blown through the hot blowing port 4.

An example of a surface-blowing heater is one which comprises a porous metallic plate 4a and an electric heater 7 provided at the hot blowing discharge port 4, and which has a ceramic coating applied to the surface of the porous metallic plate 4a. According to this arrangement, not only hot gas but also infrared rays can be discharged through the hot gas blowing port 4 so that printed circuit boards and solder paste placed thereon may be heated simultaneously and uniformly.

In the arrangement shown in Figure 1 the upper and lower surface-blowing heaters 3, 3 of each pair partially overlap each other in the longitudinal direction so as to form an upward passage area X, a collision area Y, and a downward passage area Z in the gas conduit defined between the upper and lower heaters 3, 3.

In the cooling zone C are provided cooling apparatuses 8, 8 in the top and bottom portions above and under the conveyer 2. Each cooling apparatus 8 is of the same structure as the surface blowing heaters 3, except that they are not equipped with electric heaters 7. A fan 9 is provided in the neighborhood of the cooling apparatus 8 to supply outside air to the cooling apparatus. Thus, an inert gas cooled by the outside air is circulated through the upper and lower cooling apparatuses 8, 8.

A nozzle 10 for introducing nitrogen gas into the reflow furnace 1 may be provided, as shown in Figure 1, in the first and last surface-blowing heaters 3 installed in the preheating zone P and in the cooling apparatuses 8 installed in the cooling zone. The nozzle 10 may be provided in either the upper or lower heater 3 (cooling apparatus 8) and it may be provided either inside or outside the heater 3 (cooling apparatus 8). The nozzles 10 may also be provided in each of the heaters 3 and the cooling apparatuses 8.

In the embodiment illustrated in Figure 1, air prevention zones K, K are provided in the inlet and outlet areas of the reflow furnace, i.e., upstream of the preheating zone P and downstream of the cooling zone C. The longer the air prevention zone the better.

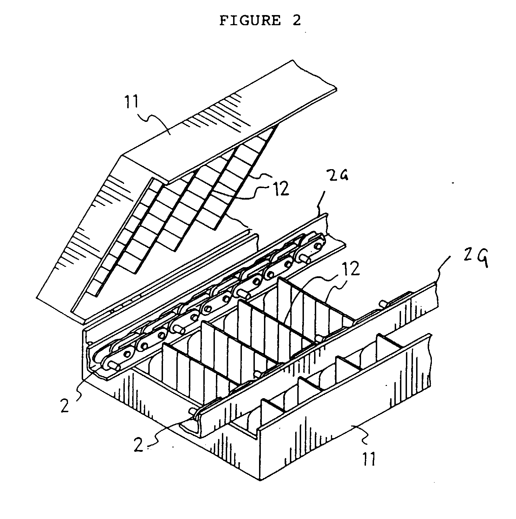

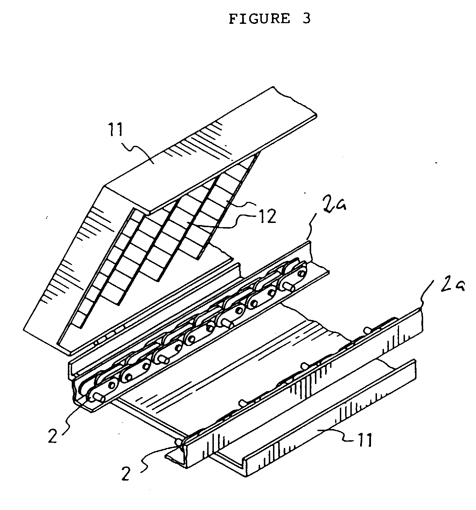

As shown in Figures 2 and 3, the air prevention zone K comprises top and bottom hollow barrel portions 11, 11, in which a series of flow-resistant members 12 and a pair of support guides 2a, 2a are installed. The top and bottom portions are hinged with each other. Figure 3 shows the case in which a series of flow-resistant members 12 are provided only in the upper portion. Along the support guides 2a the conveyer 2 passes through the furnace. The more the number of the flow-resistant members installed the better.

An example of a suitable flow-resistant member 12 is a slitted panel of heat-resistant pieces of resin. Such a heat-resistant piece may be one which can resist hot blowing without deformation in shape or degradation in properties. When the pieces are flexible, they do not move the electronic components installed on the printed circuit boards even if they contact the component. Needless to say, they may be provided separately from a printed circuit board which travels through the furnace along with a pair of running support guides 2a.

Now, the flow of gas in the reflow furnace of the present invention will be described.

First, the surface-blowing heaters 3 are heated and nitrogen gas is introduced into the furnace 1 through the nozzles 10. The nitrogen gas discharged out of the nozzles 10 purges air present within the furnace, and the furnace is filled with nitrogen gas. When a printed circuit board is not present within the furnace, a hot gas discharged from both of the top and bottom surface-blowing heaters 3 is free of turbulence, and the nitrogen gas flowing out of the furnace through the inlet and outlet is not turbulent. Under these conditions, no air gets into the furnace from the outside.

When the oxygen content of the atmosphere within the furnace is reduced to be low enough to carry out soldering, printed circuit boards are introduced into the furnace by the conveyer 2. When the hot gas from the surface-blowing heaters 3 runs into the boards within the furnace, a turbulent flow of hot gas is produced. The turbulent gas usually causes nitrogen gas to flow out of the furnace through the inlet and outlet.

However, according to the present invention, since a series of flow-resistant members 12 are provided at the inlet and outlet of the furnace, they can decrease turbulence of the nitrogen gas flowing out of the furnace. Thus, air outside the furnace does not have a chance to enter the furnace. Experiment:

A reflow furnace having a structure shown in Figures 1 and 2 was used. It had flow-resistant members 12 composed of 25 rows of slitted curtains disposed at intervals of 15 mm. Each slitted curtain comprised a large number of pieces of polyimide film (0.075 x 40 x 10 mm). Such a series of slit curtains was provided on the upper and bottom portion of the air prevention zone.

While nitrogen gas was introduced into the furnace through the nozzles 12 at a total flow rate of 180 1/min, soldering of printed circuit boards using a solder paste of the RMA type was carried out.

The content of oxygen gas within the furnace was 100 ppm (volume), and soldering was carried out without any defects being provided.

In contrast, when the experiment was carried out under the same conditions using a reflow furnace having no flow-resistant zone, the oxygen content within the furnace was 20,000 ppm (volume) and many soldering defects were found.

Thus, according to the present invention, as a result of providing a flow-resistant member of a simple structure, air from the outside does not get into the furnace. The furnace of the present invention is easier to use than a conventional reflow furnace using a shutter and pusher. Furthermore, the amount of nitrogen introduced into the furnace may be reduced markedly.

## Claims

1. A solder reflow furnace (1) having an inlet port (4) and an outlet port (5), a conveyer (2) for carrying printed circuit boards through said inlet port, said furnace and said outlet port, piping to supply an inert gas into the furnace to maintain an inert gas atmosphere within the furnace, gas flow resistant members (12) allowing the passage of said boards characterized in that said inlet and said outlet ports are such that said inert gas may flow out the furnace through said inlet and said outlet ports and in that said gas flow resistant members (12) are provided in air prevention zones upstream said inlet port and downstream said outlet port to decrease the turbulence of the inert gas flowing out of the furnace, whereby preventing outsideair from flowing into the furnace.

2. A solder reflow furnace as set forth in Claim 1 wherein the furnace further comprises a preheating zone (P), a main heating zone (R), and a cooling zone (C), the conveyer (2) comprises a pair of support guides (2a) extending through the furnace, and the air prevention zone (K) is provided on each of the inlet (4) and outlet ports (5) of the furnace.

3. A solder reflow furnace as set forth in Claim 1 or 2 wherein the gas-flow-resistant member (12) is provided on both the top and bottom portions of the air prevention zone (K).

4. A solder reflow furnace as set forth in Claim 1 or 2 wherein the gas-flow-resistant member (12) is provided on the top portion of the air prevention zone (K).

5. A solder reflow furnace as set forth in any one of Claims 1 - 4 wherein the gas-flow-resistant member (12) comprises a flexible piece of a heat-resistant resin film.

6. A solder reflow furnace as set forth in any one of Claims 1 - 4 wherein the gas-flow-resistant member comprises a flexible piece of a heat-resisting resin plate.

7. A solder reflow furnace as set forth in any one of Claims 1 - 4 wherein the gas-flow-resistant member comprises a metal plate.

## Patentansprüche

1. Ofen (1) zum Rückflußlöten mit einer Einlaßöffnung (4) und einer Auslaßöffnung (5), einem Fördermittel (2) zur Beförderung gedruckter Schaltplatten durch die besagte Einlaßöffnung, wobei der besagte Ofen und die besagte Auslaßöffnung so verbunden sind, daß in den Ofen ein Inertgas eingeführt wird, um in dem Ofen eine Inertgasatmosphäre aufrechtzuerhalten, wobei Gasströmungswiderstandselemente (12) den Durchtritt der besagten Platten zulassen, dadurch gekennzeichnet, daß die besagte Einlaß- und Auslaßöffnung derart sind, daß das besagte Inertgas aus dem Ofen durch die besagte Einlaß- und Auslaßöffnung strömen kann, und daß die besagten Gasströmungswiderstandselemente (12) in Luftverhinderugszonen stromaufwärts der besagten Einlaßöffnung und stromabwärts der besagten Auslaßöffnung vorgesehen sind, um die Turbulenz des aus dem Ofen strömenden Inertgases herabzusetzen, wodurch das Einströmen von Außenluft in den Ofen verhindert wird.

2. Ofen zum Rückflußlöten nach Anspruch 1, wobei der Ofen außerdem eine Vorerwärmungszone (P), eine Haupterwärmungszone (R) und eine Kühlzone (C) aufweist, wobei das Fördermittel (2) ein Paar von Tragführungen (2a) aufweist, die sich durch den Ofen erstrecken, und die Luftverhinderungszone (K) sowohl an der Einlaß- (4) wie der Auslaßöffnung (5) des Ofens vorgesehen ist.

3. Ofen zum Rückflußlöten nach Anspruch 1 oder 2, wobei das Gasströmungswiderstandselement (12) sowohl an dem oberen Abschnitt wie dem Bodenabschnitt der Luftverhinderungszone (K) vorgesehen ist.

4. Ofen zum Rückflußlöten nach Anspruch 1 oder 2, wobei das Gasströmungswiderstandselement (12) an dem oberen Abschnitt der Luftverhinderungszone (K) vorgesehen ist.

5. Ofen zum Rückflußlöten nach einem der Ansprüche 1 bis 4, wobei das Gasströmungswiderstandselement (12) ein flexibles Teil eines wärmefesten Kunstharzfilms umfaßt.

6. Ofen zum Rückflußlöten nach einem der Ansprüche 1 bis 4, wobei das Gasströmungswiderstandselement (12) ein flexibles Teil einer wärmefesten Kunstharzplatte umfaßt.

7. Ofen zum Rückflußlöten nach einem der Ansprüche 1 bis 4, wobei das Gasströmungswiderstandselement (12) eine Metallplatte umfaßt.

## Revendications

1. Four de soudage à reflux (1) présentant un orifice d'entrée (4) et un orifice de sortie (5), un transporteur (2) destiné à transporter des panneaux de circuits imprimés à travers ledit orifice d'entrée, ledit four et ledit orifice de sortie, une canalisation servant à introduire un gaz inerte dans le four pour entretenir une atmosphère de gaz inerte dans le four, et des éléments de résistance à l'écoulement gazeux (12) qui laissent passer lesdits panneaux, caractérisé en ce que lesdits orifices d'entrée et de sortie sont tels que ledit gaz inerte puisse sortir du four à travers lesdits orifices d'entrée et de sortie et en ce que lesdits éléments de résistance à l'écoulement gazeux (12) sont prévus dans des zones d'arrêt d'air situées en amont dudit orifice d'entrée et en aval dudit orifice de sortie afin de réduire la turbulence du gaz inerte qui sort du four, en empêchant ainsi l'air extérieur de pénétrer dans le four.

2. Four de soudage à reflux selon la revendication 1, dans lequel le four comprend en outre une zone de préchauffage (P), une zone de chauffage principale (R) et une zone de refroidissement (C), le transporteur (2) comprenant une paire de guides supports (2a) qui s'étendent à travers le four, et ladite zone d'arrêt d'air (K) est prévue sur chacun desdits orifices d'entrée (4) et de sortie (5) du four.

3. Four de soudage à reflux selon la revendication 1 ou 2, dans lequel l'élément de résistance à l'écoulement gazeux (12) est prévu sur les portions supérieure et inférieure de la zone d'arrêt d'air (K).

4. Four de soudage à reflux selon la revendication 1 ou 2, dans lequel l'élément de résistance à l'écoulement gazeux (12) est prévu sur la portion supérieure de la zone d'arrêt d'air (K).

5. Four de soudage à reflux selon une quelconque des revendications 1 à 4, dans lequel l'élément de résistance à l'écoulement gazeux (12) comprend une pièce flexible en film de résine résistante à la chaleur.

6. Four de soudage à reflux selon une quelconque des revendications 1 à 4, dans lequel l'élément de résistance à l'écoulement gazeux comprend une pièce flexible en plaque de résine résistante à la chaleur.

7. Four de soudage à reflux selon une quelconque des revendications 1 à 4, dans lequel l'élément de résistance à l'écoulement gazeux comprend une plaque métallique.
